# EUROPEAN PATENT APPLICATION

(11) **EP 4 672 876 A1**
(43) Date of publication of application: **31.12.2025**
(21) Application number: 23923711.8
(22) Date of filing: 16.10.2023
(51) Int. Cl.: H05K 5/02

(54) **DECORATIVE MEMBER, HOUSING, AND ELECTRONIC DEVICE**

(30) Priority: 24.02.2023 CN 202320376437 U
(71) Applicant: BYD Company Limited, Shenzhen, Guangdong 518118 (CN)
(72) Inventor: YUAN, Sun, Shenzhen, Guangdong 518118 (CN); ZHAO, Lihong, Shenzhen, Guangdong 518118 (CN); ZHAO, Fei, Shenzhen, Guangdong 518118 (CN); ZHU, Qiyu, Shenzhen, Guangdong 518118 (CN); LUO, Wenhai, Shenzhen, Guangdong 518118 (CN)
(74) Representative: Mathys & Squire
(86) International application number: PCT/CN2023/124777
(87) International publication number: WO 2024/174546

(57) **Abstract**

A decorative member (100, 100A, 100B), a housing (1000), and an electronic device (1002). The decorative member (100, 100A, 100B) comprises a substrate layer (10) and an optical texture layer (30), the optical texture layer (30) being arranged on the substrate layer (10), and the optical texture layer (30) comprising a plurality of stripes (301) extending in a preset direction, wherein at least some of the stripes (301) comprise a first texture structure (31) provided on the substrate layer (10) and a plurality of second texture structures (32) provided on the side of the first texture structure (31) facing away from the substrate layer (10), the heights of the plurality of second texture structures (32) varying randomly. The first texture structure (31) has a decorative effect of light and shadow bright lines; and the second texture structure (32) has a frosted effect, such that the decorative member (100, 100A, 100B) achieves a light and shadow effect of a frosted matte texture.

## Description

This application claims priority to Chinese Patent Application No. 202320376437.X, filed with the China National Intellectual Property Administration on February 24, 2023 and entitled "DECORATIVE MEMBER, HOUSING, AND ELECTRONIC DEVICE", which is incorporated herein by reference in its entirety.

### TECHNICAL FIELD

This application relates to the field of optical decorative element technologies, and in particular, to a decorative member, a housing, and an electronic device.

### BACKGROUND

In the related technology, mutually independent texture layers and frosted layers are formed on a base of a decorative member by using different processing techniques, so that the decorative member has a frosted texture and light-shadow aesthetics. However, such a manufacturing method for such a decorative member involves complicated procedures, high costs, and low product yields.

### SUMMARY

An objective of this disclosure is to provide a decorative member, a housing of an electronic device, and an electronic device, to resolve problems of a complex manufacturing process, high costs, and a low product yield in the related technology.

According to a first aspect, this application provides a decorative member, including:
a base layer; and
an optical texture layer, wherein the optical texture layer is disposed on the base layer, the optical texture layer includes a plurality of stripes extending in a preset direction, at least a part of the plurality of stripes including a first texture structure disposed on the base layer and a plurality of second texture structures, parts of the plurality of second texture structures being disposed on a side of the first texture structure that faces away from the base layer, and heights of the plurality of second texture structures varying randomly.

With reference to the first aspect, in some implementations of the first aspect, the parts of the plurality of second texture structures are configured as an undulating structure in a height direction of the first texture structure, the undulating structure including a plurality of protrusions protruding outwardly relative to the first texture structure and/or a plurality of recesses recessed inwardly relative to the first texture structure, and heights of the plurality of protrusions varying randomly; and/or heights of the plurality of recesses varying randomly.

With reference to the first aspect, in some implementations of the first aspect, a ratio of a height of the second texture structure to a maximum height of the first texture structure ranges from 5% to 25%.

With reference to the first aspect, in some implementations of the first aspect, the parts of the plurality of second texture structures are arranged in a scattered manner on the first texture structure.

With reference to the first aspect, in some implementations of the first aspect, a region of the optical texture layer corresponding to the first texture structure is divided into a plurality of texture regions arranged in a chessboard pattern, each second texture structure in the plurality of second texture structures being disposed in a corresponding texture region in the plurality of texture regions, a quantity of the plurality of second texture structures being less than or equal to a quantity of the plurality of texture regions, and a size of each texture region in the plurality of texture regions ranges being from 0.5 µm*0.5 µm to 2.5 µm*2.5 µm.

With reference to the first aspect, in some implementations of the first aspect, the optical texture layer includes a first side and a second side that is disposed opposite to the first side, and sizes of the plurality of texture regions vary in a gradient from the first side to the second side; and/or a random variation range of the height of the second texture structure varies in a gradient from the first side to the second side.

With reference to the first aspect, in some implementations of the first aspect, the other parts of the plurality of second texture structures are disposed in a region between two adjacent stripes corresponding to the optical texture layer, and are arranged in a scattered manner.

With reference to the first aspect, in some implementations of the first aspect, the decorative member further includes a glitter sand layer, wherein the glitter sand layer and the optical texture layer are disposed in a spliced arrangement on the base layer.

With reference to the first aspect, in some implementations of the first aspect, the plurality of stripes extend continuously in the preset direction; or the plurality of stripes includes a plurality of first stripes and a plurality of second stripes, an extension direction of the first stripe intersecting an extension direction of the second stripe, the plurality of second stripes partitioning at least a part of the first stripes, and a first region corresponding to the plurality of first stripes being spliced with a second region corresponding to the plurality of second stripes.

According to a second aspect, this application provides a housing, including the foregoing decorative member.

According to a third aspect, this application provides an electronic device, including the foregoing housing.

According to the decorative member, the housing, and the electronic device provided in this application, the plurality of second texture structures are disposed on a side of the first texture structure that faces away from the base layer, and heights of the plurality of second texture structures vary randomly, wherein the first texture structure has a decorative effect of light-shadow bright rays, and the second texture structure has a frosted effect, so that the decorative member achieves a light-shadow effect with a frosted matte texture, and an overall effect of the decorative member is richer, more diversified, and more aesthetic. In addition, because the second texture structure is directly disposed on the first texture structure, the manufacturing process is simple, costs are low, and a product yield is high.

### BRIEF DESCRIPTION OF DRAWINGS

To describe the technical solutions in embodiments of this application or the conventional technology more clearly, the following briefly describes the accompanying drawings required for describing the embodiments or the conventional technology. Clearly, the accompanying drawings in the following description show merely some embodiments of this application, and a person of ordinary skill in the art may still derive other drawings from these accompanying drawings without creative efforts.
FIG. 1 is a top view of a decorative member according to a first embodiment of this application;
FIG. 2 is a partial cross-sectional view of the decorative member in FIG. 1 along a line A-A;
FIG. 3 is a top view of a decorative member according to a second embodiment of this application;
FIG. 4 is a top view of a texture layer of the decorative member in FIG. 1;
FIG. 5 is a diagram of a frosted matte effect of the decorative member in FIG. 4;
FIG. 6 is a cross-sectional view of a decorative member according to a third embodiment of this application;
FIG. 7 is a schematic diagram of a housing according to an embodiment of this application; and
FIG. 8 is a schematic diagram of an electronic device according to an embodiment of this application.

**Description of reference signs of main elements**

| | |
|---|---|
| Decorative member | 100, 100A, 100B |
| Base layer | 10 |
| First region | 11 |
| Second region | 12 |
| Optical texture layer | 30 |
| Stripe | 301 |
| First stripe | 310 |
| Second stripe | 320 |
| Strip-shaped recess | 302 |
| First region | 303 |
| Second region | 304 |
| Texture region | 305 |
| First side | 3051 |
| Second side | 3052 |
| First texture structure | 31 |
| First surface | 311 |
| Second surface | 312 |
| Second texture structure | 32 |
| Protrusion | 321 |
| Recess | 322 |
| Third texture structure | 33 |
| Composite texture structure | 300 |
| Glitter sand layer | 50 |
| Housing | 1000 |
| Outer surface | 1006 |
| Electronic device | 1002 |
| Processor | 1004 |

This application is further described in the following specific implementations with reference to the accompanying drawings.

### DESCRIPTION OF EMBODIMENTS

The following clearly and completely describes technical solutions in implementations of this disclosure with reference to the accompanying drawings in implementations of this disclosure.

To understand the foregoing objectives, features, and advantages of this disclosure more clearly, the following describes this disclosure in detail with reference to the accompanying drawings and specific implementations. It should be noted that, in absence of conflicts, the implementations and the features in the implementations of this disclosure may be mutually combined.

The following clearly and completely describes the technical solutions in embodiments of this application with reference to the accompanying drawings in embodiments of this application. Clearly, the described embodiments are merely some rather than all of embodiments of this application. Based on embodiments of this application, all other embodiments obtained by a person of ordinary skill in the art without creative efforts fall within the protection scope of this application.

It may be understood that the terms in the specification, claims, and accompanying drawings of this application are merely intended to describe specific embodiments, and are not intended to limit this application. The terms "first", "second", and the like in the specification, claims, and accompanying drawings of this application are used to distinguish between different objects, and are not used to describe a specific sequence. Singular forms "a/an" and "the" are also intended to include plural forms unless otherwise explicitly stated in the context. The term "comprise/include" and any variations thereof are intended to cover non-exclusive inclusion. In addition, this application may be implemented in a plurality of different forms, and is not limited to embodiments described in this embodiment. The following specific embodiments are provided to facilitate a clearer and more thorough understanding of content disclosed in this application. Words indicating orientations such as upper, lower, left, and right are only used relative to positions of structures shown in the corresponding accompanying drawings.

In the description of this application, it should be noted that, unless otherwise explicitly specified or defined, the terms "mount", "interconnection", "connection", and "disposed on ..." will be understood in a broad sense. For example, the connection may be comprehended as being fixedly connected, detachably connected, or integrally connected; or mechanically connected; or directly connected or indirectly connected by using an intermediate medium, or in an internal communication between two elements. A person of ordinary skill in the art may understand specific meanings of the foregoing terms in this application based on specific situations.

The following first briefly describes basic concepts used in embodiments of this application.

In the description of this application, the term "preset direction" is an extension direction of a stripe. For example, generally, for a strip-shaped object, a length direction of the strip-shaped object is an extension direction of the strip-shaped object. For example, in embodiments of this application, the stripe is a top-view line pattern of a grating.

In the description of this application, the term "varying in a gradient " is used to indicate that sizes of a plurality of texture regions or a random variation range of a height of a second texture structure are/is increased or decreased in a gradient in a specified direction, wherein the specified direction is a direction from a first side to a second side.

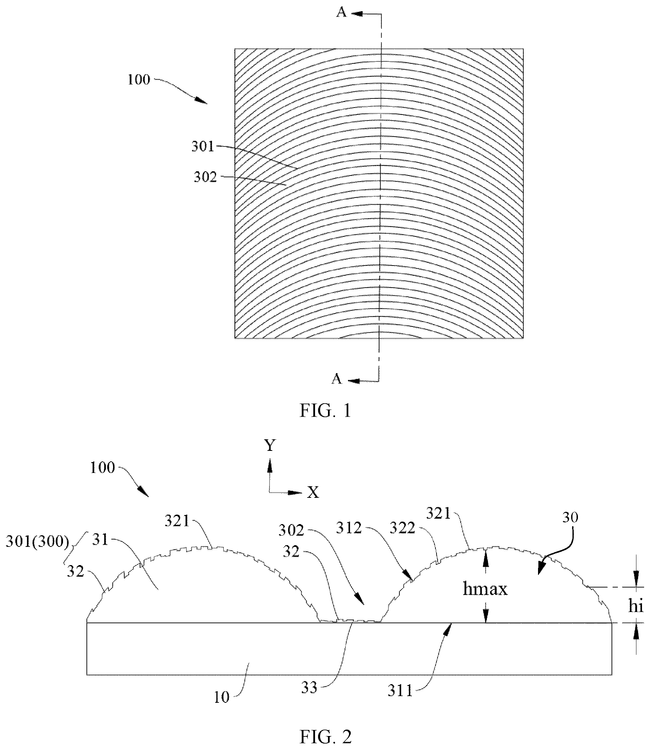

Refer to FIG. 1 and FIG. 2, FIG. 1 is a top view of a decorative member 100 according to a first embodiment of this application. FIG. 2 is a partial cross-sectional view of the decorative member 100 in FIG. 1 along a line A-A. The decorative member 100 includes a base layer 10 and an optical texture layer 30 that is disposed on the base layer 10. When light passes through the optical texture layer 30, the light is reflected, refracted, and so on, so as to form a decorative effect of light-shadow bright rays.

In some embodiments, the base layer 10 and the optical texture layer 30 may be an integral structure. The base layer 10 and the optical texture layer 30 are formed by pressing a photocurable adhesive layer, a thermal curable adhesive layer, a thermoplastic film, or the like by using a mold and further curing. In some other embodiments, the base layer 10 and the optical texture layer 30 may alternatively be separate structures. The base layer 10 may be made of any transparent material, and the optical texture layer 30 is a photocurable adhesive layer, a thermal curable adhesive layer, or a thermoplastic film. In an embodiment, a film is first formed on the base layer 10, and the film is pressed by using a corresponding mold before the film is cured to form the optical texture layer 30.

The base layer 10 may be configured as a plate-shaped structure, a curved surface-shaped structure, another regularly or irregularly shaped structure, or the like. For example, in this embodiment, the base layer 10 is configured as a plate-shaped structure. The base layer 10 includes a flat and continuous surface. The flat and continuous surface may be a plane and/or a curved surface. The optical texture layer 30 is formed on the flat and continuous surface of the base layer 10, thereby facilitating processing and molding of the optical texture layer 30. The base layer 10 may be configured as but is not limited to a composite plate such as a polycarbonate (polycarbonate, PC film) film, a polyethylene terephthalate (polyethylene terephthalate, PET) film, a glass substrate, or polycarbonate+polymethyl methacrylate (polycarbonate+polymethyl methacrylate, PC/PMMA).

For example, in this embodiment, the optical texture layer 30 includes a plurality of stripes 301 extending in a preset direction. At least a part of the stripes 301 includes a first texture structure 31 disposed on the base layer 10 and a plurality of second texture structures 32, and parts of the plurality of second texture structures 32 are disposed on a side of the first texture structure 31 that faces away from the base layer 10. Heights of the plurality of second texture structures 32 vary randomly. In some embodiments, a maximum height of each second texture structure 32 in the plurality of second texture structures 32 ranges from 0.05 µm to 7 µm.

Optionally, in this embodiment, all of the stripes 301 include the first texture structure 31 and the second texture structure 32, so that an overall structure of the decorative member 100 presents a frosted effect.

According to the decorative member 100 provided in this application, the plurality of second texture structures 32 are disposed on the side of the first texture structure 31 that faces away from the base layer 10, and the heights of the plurality of second texture structures 32 vary randomly, wherein the first texture structure 31 has a decorative effect of light-shadow bright rays, and the second texture structure 32 has a frosted effect, so that the decorative member 100 achieves a light-shadow effect with a frosted matte texture, and an overall effect of the decorative member 100 is richer, more diversified, and more aesthetic. In addition, because the second texture structure 32 is directly disposed on the first texture structure 31, a manufacturing process is simple, costs are low, and a product yield is high.

It should be noted that the purpose of FIG. 2 is only to schematically describe a disposing manner between the base layer 10 and the optical texture layer 30, and is not to impose a specific limitation on a connection location, a connection relationship, a specific construction, and the like of each element. FIG. 2 is merely an example of the decorative member 100, and does not constitute a limitation on the decorative member 100. The decorative member 100 may include more or fewer components than those shown in FIG. 2, or combine some components, or include different components. For example, the decorative member 100 may further include a functional layer such as a coloring layer and a reflecting layer.

A shape of the stripe 301 (that is, an extension path of the stripe 301) may be configured as but is not limited to one or a combination of more than one of a linear shape, a curve shape, and a broken line shape. The curve shape may be a regular curve shape or an irregular curve shape. By way of example but not limiting, the curve shape is an arc shape, a parabolic shape, a sine curve, a cosine curve, or the like. Extension directions of the plurality of stripes 301 may be the same or different. For example, as shown in FIG. 1, in this embodiment, the plurality of stripes 301 extend continuously in the preset direction, so that the light-shadow bright rays of the optical texture layer 30 have a stronger overall sense. The extension directions of the plurality of stripes 301 are configured into a same shape, that is, configured into an arc shape. Different stripes 301 have a same radius of curvature. In some embodiments, different stripes 301 have different radiuses of curvature. Optionally, the plurality of stripes 301 may be disposed in a radial or concentric circular shape on the base layer 10. It should be noted that the stripe 301 is a strip-shaped protrusion disposed on the base layer 10. In this embodiment, two adjacent strip-shaped protrusions may be spaced apart from each other. In some embodiments, two adjacent strip-shaped protrusions are disposed adjacent to each other. A strip-shaped recess 302 is formed between two adjacent stripes 301, so that the decorative member 100 can present a light-shadow effect with alternation of light and shade as a texture height varies, and has a good decorative effect.

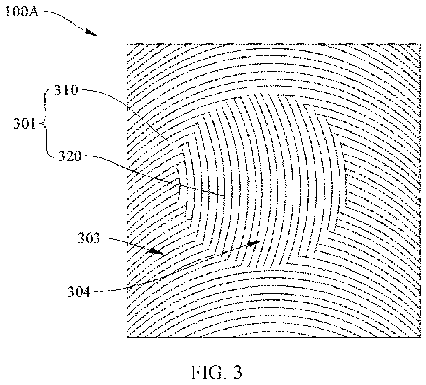

In some embodiments, referring to FIG. 3, FIG. 3 is a top view of a decorative member 100A according to a second embodiment of this application. As shown in FIG. 3, a plurality of stripes 301 include a plurality of first stripes 310 and a plurality of second stripes 320. An extension direction of the first stripe 310 intersects an extension direction of the second stripe 320. In an embodiment, an extension trajectory of the first stripe 310 intersects an extension trajectory of the second stripe 320. In an embodiment, an extension trajectory of at least a part of the plurality of first stripes 310 intersects an extension trajectory of a part of the plurality of second stripes 320. In another embodiment, an extension trajectory of a part of the plurality of second stripes 320 does not intersect the plurality of first stripes 310. The plurality of second stripes 320 partition at least a part of the first stripes 310. In an embodiment, orthographic projections of the plurality of second stripes 320 on the base layer 10 surround orthographic projections of the plurality of first stripes 310 on the base layer 10. A first region 303 corresponding to the plurality of first stripes 310 is spliced with a second region 304 corresponding to the plurality of second stripes 320, that is, the first region 303 and the second region 304 are spliced and distributed in a jigsaw puzzle shape, so that a user can see different images from different angles, and a gradient light-shade effect of the first region 303 and the second region 304 and continuity of light and shadow flowing at different angles can be ensured, which has a better decorative effect. In an embodiment, the plurality of first stripes 303 and the plurality of second stripes 320 jointly cover the entire base layer 10.

It should be noted that a cross section of the first texture structure 31 is a cross section of the first texture structure 31 in a width direction of the first texture structure 31, and the width direction of the first texture structure 31 is a normal direction of an extension path of the stripe 301, that is, a direction perpendicular to a tangential direction of the stripe 301. For a clearer description, an X-axis direction is defined as a width direction of the optical texture layer 30, and a Y-axis direction is defined as a height direction of the optical texture layer 30. For example, an arrow direction in the Y-axis direction is upward, and a direction opposite to the arrow direction in the Y-axis direction is downward.

The first texture structure 31 may be but is not limited to one or a combination of a prism, a straight cylindrical mirror, a curve cylindrical mirror, a CD pattern, a wire drawing pattern, or a short line, so that different optical textures can be formed, and different visual effects can be presented. A shape of the cross section of the first texture structure 31 may be but is not limited to an arc, a triangle, a quadrilateral, a trapezoid, a regular polygon, or an irregular polygon. The triangle may be but is not limited to a right angled triangle, an equilateral triangle, or an isosceles triangle. For example, in this embodiment, the shape of the cross section of the first texture structure 31 is an arc, for example, a semicircle. A height of the first texture structure 31 in the height direction of the optical texture layer 30 gradually decreases from a middle to two ends. Heights of the two ends of the first texture structure 31 are zero or close to zero.

The plurality of second texture structures 32 are configured as an undulating structure in a height direction of the first texture structure 31. The undulating structure includes a plurality of protrusions protruding outward relative to the first texture structure 31 and/or a plurality of recesses recessed inward relative to the first texture structure 31. Heights of the plurality of protrusions vary randomly; and/or heights of the plurality of recesses vary randomly. The undulating structure can diffusely reflect light, so that the decorative member 100 can present an optical effect with a frosted matte. At least one parameter in lengths, widths, or heights of the plurality of second texture structures 32 varies, so that the second texture structure 32 obtains different diffuse reflection effects, thereby improving a stereoscopic effect and aesthetics of the decorative member 100. Specifically, in this embodiment, the first texture structure 31 includes a first surface 311 in a contact connection to the base layer 10 and a second surface 312 connected to the first surface 311 that protrudes outward relative to the first surface 311. The undulating structure is formed on the second surface 312. The second texture structure 32 is arranged in a chessboard shape in an extension direction of the first texture structure 31, that is, the second texture structure 32 is a plurality of chessboard blocks, with heights varying randomly, disposed on the second surface 312 of the first texture structure 31.

The plurality of second texture structures 32 are arranged in a scattered manner on the first texture structure 31. The plurality of second texture structures 32 may be arranged in a lattice shape, or may be arranged in a non-lattice shape. It should be noted that the term "scattered manner" means that center points of orthographic projections of the second texture structures 32 in the height direction of the first texture structure 31 are distributed in a scattered manner.

In some embodiments, two adjacent stripes 301 are spaced apart from each other. A plurality of second texture structures 32 are further disposed between the two adjacent stripes 301, so that the decorative member 100 achieves a frosted effect as a whole. Optionally, a plurality of second texture structures 32 arranged in a scattered manner are further disposed in a region between two adjacent stripes 301 corresponding to the optical texture layer 30. In some other embodiments, because a spacing between the two adjacent stripes 301 is small, the second texture structure 32 may not be disposed between the two adjacent stripes 301. In some other embodiments, the two adjacent stripes 301 are disposed adjacent to each other. For example, in this embodiment, the optical texture layer 30 further includes a third texture structure 33 connected between two adjacent first texture structures 31. The second texture structure 32 is disposed on a side of the third texture structure 33 that faces away from the base layer 10, thereby further improving a light-shadow effect with a frosted matte texture of the decorative member 100. The third texture structure 33 is a straight panel structure. A height of the third texture structure 33 is less than a height of the first texture structure 31. In some other embodiments, the optical texture layer 30 is provided with only the second texture structure 32 between two adjacent first texture structures 31, rather than the third texture structure 33. In some other embodiments, the optical texture layer 30 may not include the second texture structure 32 or the third texture structure 33 between two adjacent first texture structures 31.

It may be understood that a variation range of a height of the second texture structure 32 also affects light and shadow of the decorative member 100. The variation range of the height of the second texture structure 32 is based on a value of a maximum height of the first texture structure 31. A smaller variation range of the height of the second texture structure 32 indicates slighter impact on the light and shadow of the first texture structure 31 and a weaker frosted matte texture. A larger variation range of the height of the second texture structure 32 indicates greater impact on the light and shadow of the first texture structure 31 and a stronger frosted matte texture, and even a frosted feature is visible to naked eyes. Optionally, in some embodiments, a ratio of the height of the second texture structure 32 to the maximum height of the first texture structure 31 ranges from 5% to 25%, that is, the height of the second texture structure 32 accounts for 5% to 25% of the maximum height of the first texture structure 31, so that the second texture structure 32 presents a concave-convex-shaped texture on the first texture structure 31, and a side surface of the optical texture layer 30 that faces away from the base layer 10 is no longer a smooth surface, but an undulating surface, which increases irregular reflection of reflected light in different directions to achieve a matte effect, thereby ensuring that the decorative member 100 presents a light-shadow effect with a frosted matte texture. Specifically, a composite texture structure 300 is formed by compositing the first texture structure 31 and the second texture structure 32, which simplifies a manufacturing process of the optical texture layer 30, and provides low costs and a high product yield. A range of a height of the composite texture structure 300 is hi±hmax*k, wherein hi represents a height value of the first texture structure 31 in a specific region, hmax represents a maximum height value of the first texture structure 31, and k represents a ratio of the height of the second texture structure 32 to the maximum height of the first texture structure 31.

For example, if the maximum height value of the first texture structure 31 is 10 µm, a variation range of the height of the second texture structure 32 is 10% of the maximum height value of the first texture structure 31, and the height value of the first texture structure 31 in a specific region is 5 µm, the range of the height of the composite texture structure 300 is 5 µm±10 µm*10% (that is, 4 µm to 6 µm). That is, the height of the composite texture structure 300 is a random value among 5 µm±10 µm*10%. In this embodiment, a minimum height of the composite texture structure 300 is 0 µm.

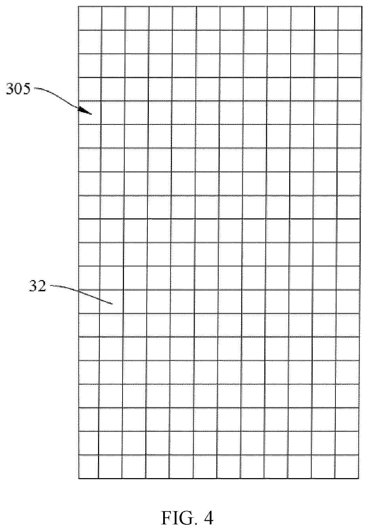

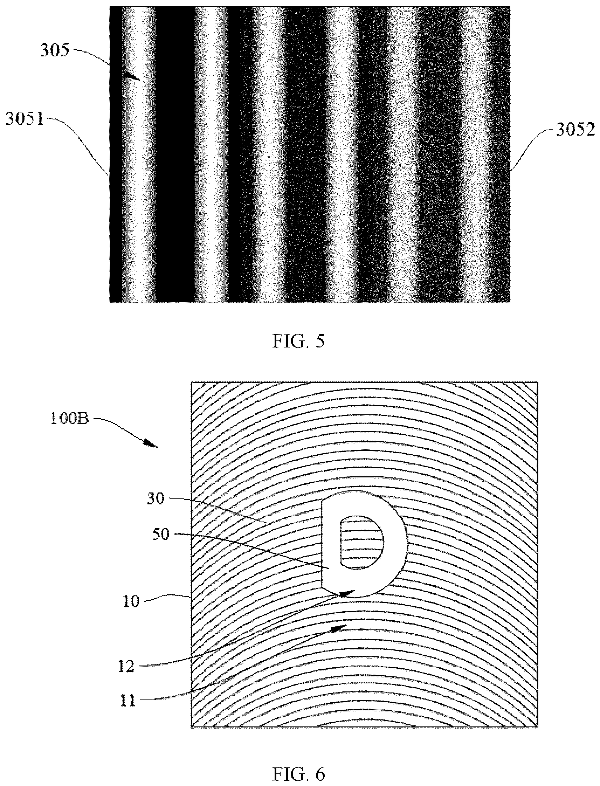

Referring to FIG. 4 and FIG. 5, FIG. 4 is a top view of the texture layer 30 of the decorative member 100 in FIG. 1. FIG. 5 is a diagram of a frosted matte effect of the decorative member 100 in FIG. 4.

For example, in this embodiment, a region of the optical texture layer 30 corresponding to the first texture structure 31 is divided into a plurality of texture regions 305 arranged in a chessboard shape, each second texture structure 32 is disposed in a corresponding texture region 305, and a quantity of second texture structures 31 is less than or equal to a quantity of texture regions 305. Each second texture structure 32 covers a corresponding texture region 305. In some embodiments, the quantity of second texture structures 32 is in a one-to-one correspondence with the quantity of texture regions 305, that is, one second texture structure 32 is disposed in each texture region 305. In some embodiments, the second texture structure 32 may not be disposed in at least one texture region 305.

It will be understood that a smaller size of the texture region 305 indicates slighter impact on a light-shadow effect of the first texture structure 31 and a weaker frosted matte texture. A larger size of the texture region 305 indicates greater impact on the light-shadow effect of the first texture structure 31 and a stronger frosted matte texture, and even a frosted feature is visible to naked eyes. The size of the texture region 305 is 0.5 µm*0.5 µm to 2.5 µm*2.5 µm, thereby ensuring that the decorative member 100 presents a light-shadow effect with a frosted matte texture. The size of the texture region 305 may be but is not limited to 0.5 µm*0.5 µm, 1.0 µm*1.0 µm, 2.0 µm*2.0 µm, or 2.5 µm*2.5 µm. It should be noted that the size of the texture region 305 is merely used for description, and does not constitute a specific limitation. The size of the texture region 305 needs to be designed based on an actual product design. Sizes of the plurality of texture regions 305 may be the same. Alternatively, some texture regions 305 may have a same size, and the other texture regions 305 may have different sizes. Alternatively, sizes of the plurality of texture regions 305 are totally different. This is not specifically limited in this application.

In this embodiment, a region between two adjacent stripes 301 corresponding to the optical texture layer 30 is also divided into a plurality of texture regions 305, and the second texture structure 32 is also disposed in at least a part of the texture regions 305, so that the decorative member 100 achieves a more uniform frosted effect as a whole. All texture regions 305 corresponding to the optical texture layer 30 are arranged in a chessboard shape, thereby facilitating processing and improving production efficiency. In some embodiments, only the region of the optical texture layer 30 corresponding to the first texture structure 31 is divided into the texture regions 305 for disposing corresponding second texture structures 32.

Optionally, in some embodiments, the optical texture layer 30 includes a first side 3051 and a second side 3052 that is disposed opposite to the first side 3051, and sizes of the plurality of texture regions 305 vary in a gradient from the first side 3051 to the second side 3052; and/or a random variation range of the height of the second texture structure 32 varies in a gradient from the first side 3051 to the second side 3052. As shown in FIG. 5, a microscopic feature of the decorative member 100 in this application is measured by using a confocal microscope. The microcosmic feature of the decorative member 100 is a frosted composite texture, and it is observed that the decorative member 100 has a light-shadow effect with frosted matte flowing. Optionally, an overall light-shadow effect and a frosted matte effect of the decorative member 100 vary in a gradient. For example, in this embodiment, a texture of the optical texture layer 30 varies in a gradient from the first side 3051 to the second side 3052, thereby achieving, from the first side 3051 to the second side 3052, an overall effect that the light and shadow vary from bright to matte, and a frosted texture varies from weak to strong. In some embodiments, the texture of the optical texture layer 30 may alternatively be designed as a strong contrast mutation effect in which a frosted texture grows out of nothing, and the light and shadow vary from bright to matte. The light-shadow effect of the first texture structure 31 and the frosted effect of the second texture are cooperated to make the overall effect of the decorative member 100 diverse and magnificent.

In some embodiments, the base layer 10 may be but is not limited to a glass substrate or a plastic film. When the base layer 10 is a glass substrate, a preparation method for the decorative member 100 includes: setting a texture parameter of the optical texture layer 30 by using software, that is, transmitting preset texture parameters of the first texture structure 31 and the second texture structure 32 to a computer; and coating photoresist on a surface of the glass substrate based on the preset texture parameter, and exposing, developing, and etching the photoresist, so as to form the decorative member 100 having the first texture structure 31 and the second texture structure 32 that are uneven, wherein the etching is wet etching or dry etching. Specifically, the glass substrate coated with the photoresist is placed in a chemical solution etching bath. A thicker part of the photoresist has a long anti-etching time, a thinner part of the photoresist has a short anti-etching time, and the thinner part of the photoresist is dissolved before the thinner part of the photoresist, to expose the glass substrate. Therefore, the first texture structure 31 and the second texture structure 32 are completely etched onto the glass substrate by setting a proper etching time for the glass substrate with the photoresist that is placed in the etching bath, and are finished by using a process such as coating, spraying, or printing to form a glass product with a light-shadow effect and a frosted matte effect. The glass substrate is used as the base layer 10. In some embodiments, optical coating may be further performed on a side of the glass substrate that faces away from the optical texture layer 30. One side of a coating layer is sprayed with an ink layer or another decorative layer.

When the base layer 10 is a plastic film, a preparation method for the decorative member 100 includes: setting a preset texture parameter of the optical texture layer 30 by using software, that is, transmitting preset texture parameters of the first texture structure 31 and the second texture structure 32 to a computer, coating photoresist on the glass substrate based on the preset texture parameter, performing lithography exposure, and performing an operation such as development, drying, and plasma cleaning to obtain a texture mold. Then, a transfer (for example, UV transfer) operation and a curing operation are performed on a texture mold to obtain a transfer mold, and then the texture is transferred to the base layer 10. For example, the first texture structure 31 and the second texture structure 32 are formed on a composite plate such as a PC film, a PET sheet, or PC/PMMA through UV transfer, so as to transfer the optical texture layer 30 on the base layer 10. The plastic film may be but is not limited to a film-shaped material or a plate-shaped material. When the plastic film is a film-shaped material, the plastic film may be attached to glass or another substrate by using a process such as coating, printing, and lamination, and used as the decorative member 100. For example, in some embodiments, a coating layer may be deposited on the optical texture layer 30, an ink layer may be printed on one side of the coating layer, and then a decorative film is attached to the glass by using a process such as lamination, to make a glass product with the decorative member 100. When the plastic film is a plate-shaped material, a plastic film finished product having the first texture structure 31 and the second texture structure 32 may be formed by hot pressing molding.

Refer to FIG. 6. FIG. 6 is a cross-sectional view of a decorative member 100B according to a third embodiment of this application. In some embodiments, the decorative member 100B further includes a glitter sand layer 50. The glitter sand layer 50 and the optical texture layer 30 are disposed in a spliced arrangement on the base layer 10. In an embodiment, an orthographic projection of the optical texture layer 30 on the base layer 10 surrounds an orthographic projection of the glitter sand layer 50 on the base layer 10. Specifically, the base layer 10 is divided into a first region 11 and a second region 12 that is spliced with the first region 11. The optical texture layer 30 is disposed in the first region 11, and the glitter sand layer 50 is disposed in the second region 12. A height of a grating corresponding to the glitter sand layer 50 varies randomly, so that the decorative member 100B can reflect a visual effect with a special shape or pattern. For example, a shape of the first region 11 may be approximately a capital letter "D" shape, so that the decorative member 100B can reflect a visual effect with the letter "D". In some embodiments, the shape of the first region 11 may further be one of a circle, a triangle, a rectangle, a trapezoid, or a polygon, or may be a combination of a plurality of graphs to form a special graph or pattern. With the glitter sand layer 50, the decorative member 100B has a better color development effect and richer colors, so that the decorative member 100B has a better texture. The glitter sand layer 50 includes several glitter sands distributed at intervals. The decorative member 100B further has a glitter sand effect, which improves aesthetics. In addition, the glitter sand layer 50 has strong wear resistance, anti-scratch and anti-fingerprint, and can prolong a service life. In addition, a size of a sand particle is adjustable, which is not limited to a glitter sand effect of a single size, so that the glitter sand effect is more diversified.

Referring to FIG. 1, FIG. 6, and FIG. 7, an embodiment of this application provides a housing 1000. The housing 1000 includes an outer surface 1006 and the foregoing decorative member 100, 100A, or 100B, that is, the decorative member 100, 100A, or 100B is used as the housing 1000 or a part of the housing 1000 of an electronic device, thereby improving a visual effect.

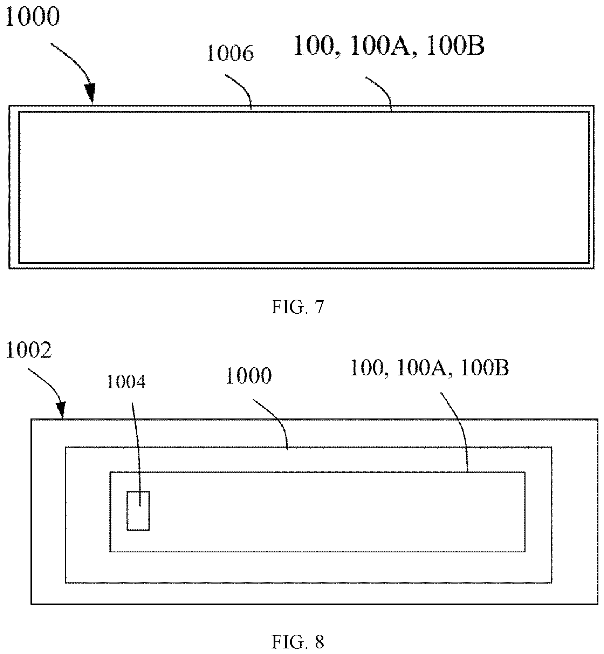

Referring to FIG. 8, an embodiment of this application further provides an electronic device 1002, including a processor 1004 and the foregoing housing 1000. The processor 1004 is covered by the housing 1000. Because the foregoing decorative member 100, 100A, or 100B is used, the housing 1000 of the electronic device 1002 can present a light-shadow effect with a frosted matte texture on a surface thereof, which has good aesthetics. The electronic device 1002 includes but is not limited to an electronic device such as a tablet computer, a mobile phone, a watch, an electronic reader, a remote control, a personal computer (personal computer, PC), a notebook computer, a personal digital assistant (personal digital assistant, PDA), a vehicle-mounted device, a network television, a wearable device, or a television.

In the foregoing embodiments, descriptions of the embodiments have respective focuses. For a part that is not detailed in an embodiment, refer to related descriptions in other embodiments.

Embodiments of this application are described in detail above. The principles and implementations of this application are described in this specification by using specific examples. The descriptions of the foregoing embodiments are merely used for helping understand the method and core ideas of this application. In addition, a person of ordinary skill in the art may change a specific implementation and an application scope based on the idea of this application. In summary, content of this specification should not be construed as a limitation on this application.

## Claims

1. A decorative member (100, 100A, 100B), comprising:
a base layer (10); and
an optical texture layer (30), wherein the optical texture layer (30) is disposed on the base layer (10), the optical texture layer (30) comprises a plurality of stripes extending in a preset direction, at least a part of the plurality of stripes comprises a first texture structure (31) disposed on the base layer (10) and a plurality of second texture structures (32), parts of the plurality of second texture structures (32) are disposed on a side of the first texture structure (31) that faces away from the base layer (10), and heights of the plurality of second texture structures (32) vary randomly.

2. The decorative member (100, 100A, 100B) according to claim 1, wherein the parts of the plurality of second texture structures (32) are configured as an undulating structure in a height direction of the first texture structure (31), the undulating structure comprises a plurality of protrusions protruding outward relative to the first texture structure (31) and/or a plurality of recesses recessed inward relative to the first texture structure (31), and heights of the plurality of protrusions vary randomly; and/or heights of the plurality of recesses vary randomly.

3. The decorative member (100, 100A, 100B) according to claim 1 or 2, wherein a ratio of a height of the second texture structure (32) to a maximum height of the first texture structure (31) ranges from 5% to 25%.

4. The decorative member (100, 100A, 100B) according to any one of claims 1 to 3, wherein the parts of the plurality of second texture structures (32) are arranged in a scattered manner on the first texture structure (31).

5. The decorative member (100, 100A, 100B) according to any one of claims 1 to 4, wherein a region of the optical texture layer (30) corresponding to the first texture structure (31) is divided into a plurality of texture regions (305) arranged in a chessboard pattern, each second texture structure (32) in the plurality of second texture structures (32) is disposed in a corresponding texture region (305) in the plurality of texture regions (305), a quantity of the plurality of second texture structures (32) is less than or equal to a quantity of the plurality of texture regions (305), and a size of each texture region (305) in the plurality of texture regions (305) ranges from 0.5 µm*0.5 µm to 2.5 µm*2.5 µm.

6. The decorative member (100, 100A, 100B) according to claim 5, wherein the optical texture layer (30) comprises a first side (3051) and a second side (3052) that is disposed opposite to the first side (3051), and sizes of the plurality of texture regions vary in a gradient from the first side (3051) to the second side (3052); and/or a random variation range of the height of the second texture structure (32) varies in a gradient from the first side (3051) to the second side (3052).

7. The decorative member (100, 100A, 100B) according to any one of claims 1 to 6, wherein the other parts of the plurality of second texture structures (32) are disposed in a region between two adjacent stripes corresponding to the optical texture layer (30), and are arranged in a scattered manner.

8. The decorative member (100, 100A, 100B) according to any one of claims 1 to 7, further comprising a glitter sand layer (50), wherein the glitter sand layer (50) and the optical texture layer (30) are disposed in a spliced arrangement on the base layer (10).

9. The decorative member (100, 100A, 100B) according to claim 8, wherein an orthographic projection of the optical texture layer (30) on the base layer (10) surrounds an orthographic projection of the glitter sand layer (50) on the base layer (10).

10. The decorative member (100, 100A, 100B) according to any one of claims 1 to 9, wherein the plurality of stripes comprise a plurality of first stripes (310) and a plurality of second stripes (320), and an extension trajectory of at least a part of the plurality of first stripes (310) intersects an extension trajectory of a part of the plurality of second stripes (320).

11. The decorative member (100, 100A, 100B) according to claim 10, wherein orthographic projections of the plurality of second stripes (320) on the base layer (10) surround orthographic projections of the plurality of first stripes (310) on the base layer (10).

12. A housing (1000), comprising an outer surface (1006) and the decorative member (100, 100A, 100B) according to any one of claims 1 to 11, wherein the decorative member (100, 100A, 100B) covers at least a part of the outer surface (1006).

13. An electronic device (1002), comprising a processor (1004) and the housing (1000) according to claim 12, wherein the processor (1004) is covered by the housing (1000).
